# EUROPEAN PATENT APPLICATION

(11) **EP 4 693 381 A2**
(43) Date of publication of application: **11.02.2026**
(21) Application number: 25176260.5
(22) Date of filing: 14.05.2025
(51) Int. Cl.: H01L 21/66, B24B 37/013, H01L 21/31, H01L 25/065

(54) **SEMICONDUCTOR PACKAGE INCLUDING A DETECTION PATTERN AND METHOD OF FABRICATING THE SAME**

(30) Priority: 08.08.2024 KR 20240106013
(71) Applicant: Samsung Electronics Co., Ltd., Suwon-si, Gyeonggi-do 16677 (KR)
(72) Inventor: HONG, Yi Koan, Suwon-si, Gyeonggi-do 16677 (KR); KIM, Ju-Hyun, Suwon-si, Gyeonggi-do 16677 (KR); PARK, Jae-Wha, Suwon-si, Gyeonggi-do 16677 (KR); CHO, Daeyeon, Suwon-si, Gyeonggi-do 16677 (KR); CHOI, Bongsik, Suwon-si, Gyeonggi-do 16677 (KR)
(74) Representative: Kuhnen & Wacker Patent- und Rechtsanwaltsbüro PartG mbB

(57) **Abstract**

A semiconductor package may include a first semiconductor die having a first width; a second semiconductor die on the first semiconductor die, the second semiconductor die having a second width that is smaller than the first width; and a mold layer at least partially covering a side surface of the second semiconductor die, and a top surface of the first semiconductor die, wherein the first semiconductor die comprises at least one first detection pattern, the at least one first detection pattern being on the top surface of the first semiconductor die and in contact with a bottom surface of the mold layer.

## Description

### CROSS-REFERENCE TO RELATED APPLICATIONS

This U.S. non-provisional patent application claims priority under 35 U.S.C. §119 to Korean Patent Application No. 10-2024-0106013, filed on August 8, 2024, in the Korean Intellectual Property Office, the entire contents of which are hereby incorporated by reference.

### BACKGROUND

At least some example embodiments relate to a semiconductor package including a detection pattern and/or to methods of fabricating the same.

A semiconductor package may be configured to facilitate the use of an integrated circuit chip as a component in an electronic product. Conventionally, a semiconductor package may include a printed circuit board (PCB) and a semiconductor chip die which is mounted on the PCB and is electrically connected to the PCB using bonding wires or bumps. With the development of the electronics industry, many studies are being conducted to improve reliability and durability of semiconductor packages.

### SUMMARY

At least some example embodiments of inventive concepts relate to a semiconductor package with improved reliability.

At least some examples embodiments of inventive concepts relate to a method of increasing a yield in a process of fabricating a semiconductor package.

According to some example embodiments of the inventive concepts, a semiconductor package may include a first semiconductor die having a first width; a second semiconductor die on the first semiconductor die, the second semiconductor die having a second width that is smaller than the first width; and a mold layer at least partially covering a side surface of the second semiconductor die, and a top surface of the first semiconductor die, wherein the first semiconductor die comprises at least one first detection pattern, the at least one first detection pattern being on the top surface of the first semiconductor die and in contact with a bottom surface of the mold layer.

According to some example embodiments of the inventive concepts, a semiconductor package may include a first semiconductor die having a first width; a second semiconductor die on the first semiconductor die, the second semiconductor die having a second width that is smaller than the first width; and a mold layer at least partially covering a side surface of the second semiconductor die, and a top surface of the first semiconductor die, wherein the second semiconductor die comprises at least one detection pattern that is on a top surface of the second semiconductor die.

According to some example embodiments of the inventive concepts, a semiconductor package may a first semiconductor die having a first width and comprising first connection pads that are in an upper portion of the first semiconductor die; outer connection terminals that are bonded to a bottom surface of the first semiconductor die; a second semiconductor die on the first semiconductor die, the second semiconductor die having a second width that is smaller than the first width and comprising second connection pads, the second connection pads located at a lower end of the second semiconductor die and in contact with the first connection pads, respectively; and a mold layer at least partially covering a side surface of the second semiconductor die and a top surface of the first semiconductor die, wherein the first semiconductor die comprises at least one first detection pattern that is on the top surface of the first semiconductor die and is in contact with a bottom surface of the mold layer, a reflectance of the first detection pattern is different from a reflectance of the top surface of the first semiconductor die, and the first detection pattern has a triangular, trapezoidal, or rectangular section.

According to some example embodiments of the inventive concepts, a method of fabricating a semiconductor package may include fabricating a wafer, the wafer including device regions and a separation region between the device regions; bonding first semiconductor dies to the device regions of the wafer; forming a detection pattern in the separation region and in at least one of the first semiconductor dies; forming a mold layer, the mold layer at least partially covering the wafer and the first semiconductor dies; performing a chemical mechanical polishing (CMP) process on the mold layer and the first semiconductor dies to partially remove the mold layer and the first semiconductor dies; and performing a singulation process to remove the separation region and the mold layer on the separation region, wherein the CMP process is performed using a CMP device, and the CMP device is configured to detect an end point using the detection pattern.

### BRIEF DESCRIPTION OF THE DRAWINGS

FIGS. 1A to 1C are plan views illustrating a semiconductor package according to some example embodiments of the inventive concepts.
FIG. 2 is a sectional view taken along a line A-A' of FIG. 1A.
FIGS. 3A and 4A are enlarged sectional views illustrating a portion 'P1' of FIG. 2.
FIGS. 3B and 4B are enlarged sectional views illustrating a portion 'P2' of FIG. 2.
FIGS. 5A to 5G are sectional views sequentially illustrating a method of fabricating the semiconductor package of FIG. 2.
FIG. 6 is a diagram illustrating a CMP device according to some example embodiments of the inventive concepts.
FIG. 7A is a sectional view illustrating a semiconductor package according to some example embodiments of the inventive concepts.
FIG. 7B is a sectional view illustrating a process of fabricating the semiconductor package of FIG. 7A.
FIG. 8A is a sectional view illustrating a semiconductor package according to some example embodiments of the inventive concepts.
FIG. 8B is a sectional view illustrating a process of fabricating the semiconductor package of FIG. 8A.
FIG. 9A is a sectional view illustrating a semiconductor package according to some example embodiments of the inventive concepts.
FIG. 9B is a sectional view illustrating a process of fabricating the semiconductor package of FIG. 9A.
FIG. 10 is a sectional view illustrating a semiconductor package according to some example embodiments of the inventive concepts.
FIG. 11 is a sectional view illustrating a semiconductor package according to some example embodiments of the inventive concepts.
FIG. 12 is a sectional view illustrating a semiconductor package according to some example embodiments of the inventive concepts.
FIG. 13 is a sectional view illustrating a semiconductor package according to some example embodiments of the inventive concepts.
FIG. 14 is a sectional view illustrating a semiconductor package according to some example embodiments of the inventive concepts.
FIG. 15 is a sectional view illustrating a semiconductor package according to some example embodiments of the inventive concepts.
FIG. 16 is a sectional view illustrating a semiconductor package according to some example embodiments of the inventive concepts.

### DETAILED DESCRIPTION

Example embodiments of the inventive concepts will now be described more fully with reference to the accompanying drawings, in which example embodiments are shown. Like reference numerals in the drawings denote like elements, and thus their description will be omitted. It will be understood that, although the terms "first", "second", etc. may be used herein to describe various elements, components, regions, layers and/or sections, these elements, components, regions, layers, and/or sections should not be limited by these terms.

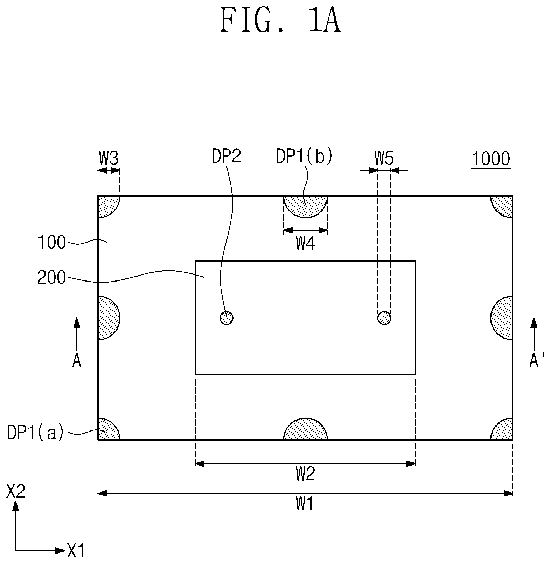

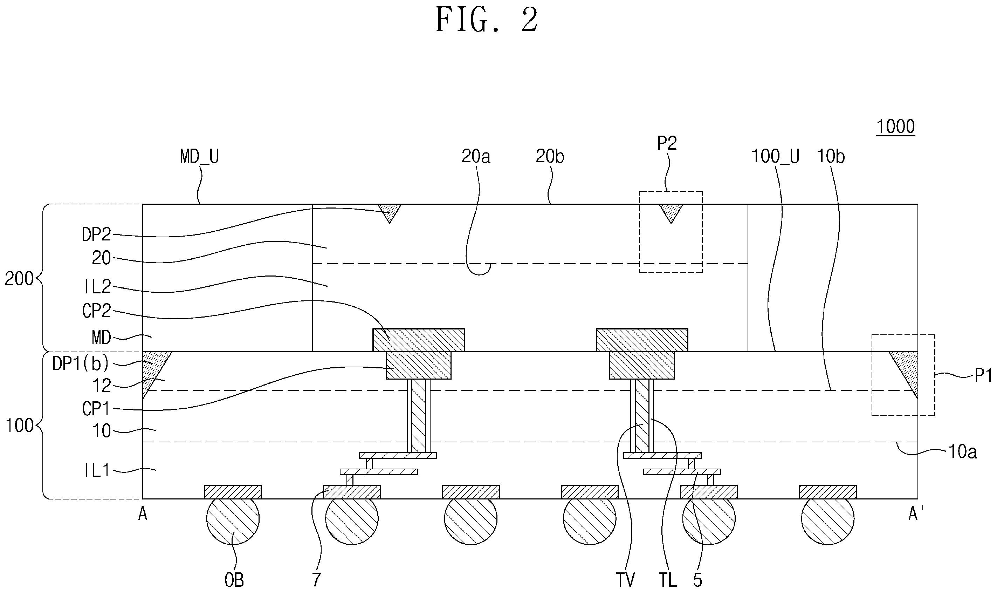

FIGS. 1A to 1C are plan views illustrating a semiconductor package according to some example embodiments of the inventive concepts. FIG. 2 is a sectional view taken along a line A-A' of FIG. 1A.

Referring to FIGS. 1A and 2, a semiconductor package 1000 according to some example embodiments may include a first semiconductor die 100, a second semiconductor die 200, and a mold layer MD. In the present specification, the term 'semiconductor die' may be referred to as a 'semiconductor chip'. The first semiconductor die 100 may have a first width W1 in a first direction X1. The second semiconductor die 200 may have a second width W2, which is smaller than the first width W1, in the first direction X1.

The first semiconductor die 100 may be or include a logic circuit chip, an application-specific integrated circuit (ASIC) chip, and/or a memory chip (e.g., a FLASH memory chip, a DRAM chip, an SRAM chip, an EEPROM chip, a PRAM chip, an MRAM chip, or an ReRAM chip). The first semiconductor die 100 may include a first substrate 10, a first interlayer insulating layer IL1, a back-side insulating layer 12, first interconnection lines 5, first bonding pads 7, first connection pads CP1, a penetration via TV, a via insulating layer TL, and first detection patterns DP1. The first substrate 10 may be or include a semiconductor wafer, which is formed of a semiconductor material (e.g., silicon), a silicon-on-insulator (SOI) wafer, and/or an insulating wafer. The first substrate 10 may include a front surface 10a and a rear surface 10b, which are opposite to each other. Although not shown, a plurality of first transistors may be disposed on the front surface 10a of the first substrate 10.

The first interlayer insulating layer IL1 may be disposed on the front surface 10a of the first substrate 10. The first interlayer insulating layer IL1 may be formed of or include at least one of silicon oxide, silicon nitride, silicon oxynitride, SiOCH, or SiCN and may have, for example, a single- or multi-layered structure. The first interconnection lines 5 having a multi-layered structure may be disposed in the first interlayer insulating layer IL1. The first interconnection lines 5 may be formed of at least one of doped polysilicon or metallic materials (e.g., aluminum, tungsten, titanium, and copper). The first interconnection lines 5 and the first transistors may be used to constitute various circuits.

The first bonding pads 7 may be disposed in a lower portion of the first interlayer insulating layer IL1. The first bonding pads 7 may be connected to the first interconnection lines 5. The first bonding pads 7 may be formed of at least one of metallic materials (e.g., aluminum, tungsten, titanium, and copper). Outer connection terminals OB may be bonded to the first bonding pads 7, respectively. The outer connection terminals OB may include at least one of conductive bumps or solder balls. The outer connection terminals OB may be formed of or include at least one of metallic materials (e.g., copper, nickel, tin, and silver).

The rear surface 10b of the first substrate 10 may be covered or at least partially covered with the back-side insulating layer 12. The back-side insulating layer 12 may be formed of or include at least one of silicon oxide, silicon nitride, silicon oxynitride, or SiCN and may have a single- or multi-layered structure. The first connection pads CP1 may be disposed in an upper portion of the back-side insulating layer 12. The first connection pads CP1 may be formed of or include at least one of metallic materials (e.g., copper).

The penetration vias TV may be provided to penetrate (for example, at least partially extend through) the first substrate 10, a portion of the first interlayer insulating layer IL1, and a portion of the back-side insulating layer 12 to connect the first connection pads CP1 to some of the first interconnection lines 5. The penetration via TV may be formed of or include at least one of metal materials (e.g., copper, tungsten, and titanium). The via insulating layer TL may be interposed between the penetration via TV and the first substrate 10. The via insulating layer TL may be formed of, for example, silicon oxide.

Referring to FIG. 1A, at least one first detection pattern DP1 may be disposed at an edge and/or corner of the first semiconductor die 100. The first detection patterns DP1 may have the same shape and size or may have different shapes and sizes. The first detection patterns DP1 may include a 1a-th detection patterns DP1(a) and a 1b-th detection patterns DP1(b). The 1a-th detection patterns DP1(a) may be disposed at the corners of the first semiconductor die 100, respectively. The 1b-th detection patterns DP1(b) may be disposed between the corners of the first semiconductor die 100. The 1a-th detection patterns DP1(a) may differ from the 1b-th detection patterns DP1(b) in their planar and/or sectional shapes. For example, the 1a-th detection patterns DP1(a) may have an arc or fan shape, when viewed in a plan view. The 1b-th detection patterns DP1(b) may have a semicircular shape, when viewed in a plan view. At least one of the 1a-th detection patterns DP1(a) may have a third width W3 in the first direction X1. At least one of the 1b-th detection patterns DP1(b) may have a fourth width W4 in the first direction X1. The fourth width W4 may be different from the third width W3. For example, the fourth width W4 may be larger than the third width W3.

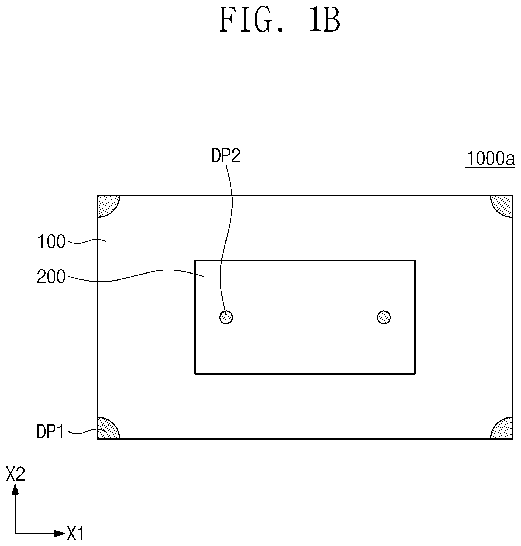

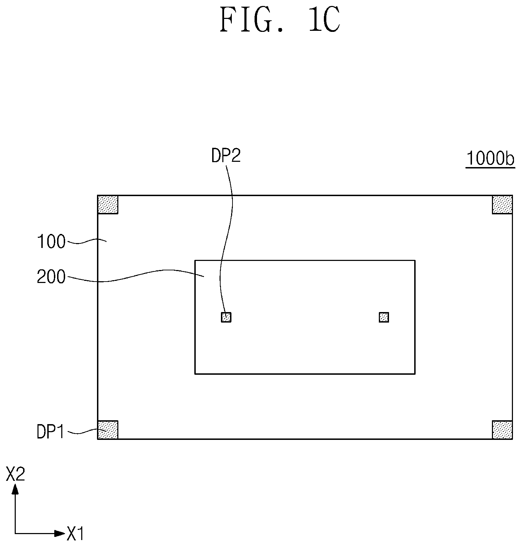

Referring to FIGS. 1B and 1C, the first detection patterns DP1 may be disposed at only the corners of the first semiconductor die 100. The first detection patterns DP1 may have an arc or fan shape, as shown in FIG. 1B, when viewed in a plan view. Alternatively, the first detection patterns DP1 may have a rectangular shape, as shown in FIG. 1C, when viewed in a plan view. However, example embodiments are not limited thereto.

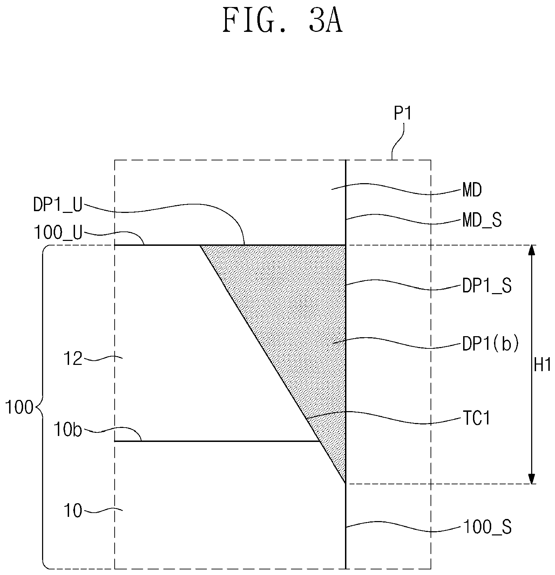

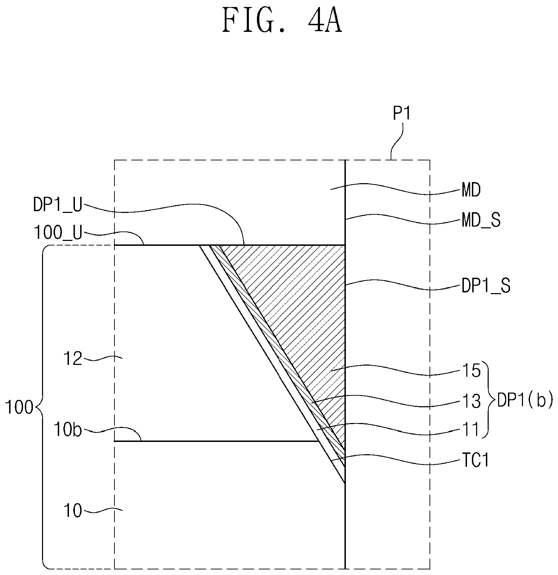

FIGS. 3A and 4A are enlarged sectional views illustrating a portion 'P1' of FIG. 2.

Referring to FIGS. 2, 3A, and 4A, a top surface DP1_U of the first detection pattern DP1 may be in contact with the mold layer MD. The top surface DP1_U of the first detection pattern DP1 may be coplanar with a top surface 100_U of the first semiconductor die 100. The first detection patterns DP1 may be provided to penetrate the (for example, at least partially extend through) back-side insulating layer 12 of the first semiconductor die 100. The first detection patterns DP1 may be further extended and may be inserted into the first substrate 10. The first detection patterns DP1 may be placed in first trenches TC1, which are formed in (for example, at least partially defined by) a side surface of the first semiconductor die 100. An inner surface of the first trench TC1 may be inclined at an angle. The first detection patterns DP1 may have a triangular section. A width of the first detection pattern DP1 may decrease as a vertical height decreases. A side surface DP1_S of the first detection pattern DP1 may be vertically aligned to (for example, coplanar with) a side surface MD_S of the mold layer MD. The side surface DP1_S of the first detection pattern DP1 may be vertically aligned to (for example, coplanar with) a side surface 100_S of the first semiconductor die 100.

A reflectance of the top surface DP1_U of the first detection pattern DP1 may be different from a reflectance of the top surface 100_U of the first semiconductor die 100. In some example embodiments, a property of the top surface DP1_U of the first detection pattern DP1 may be different from a property of the top surface 100_U of the first semiconductor die 100. For example, the top surface DP1_U of the first detection pattern DP1 may have a hydrophobic property (for example, be hydrophobic or substantially so), and the top surface 100_U of the first semiconductor die 100 may have a hydrophilic property (for example, be hydrophilic or substantially so). A friction coefficient of the top surface DP1_U of the first detection pattern DP1 may be different from a friction coefficient of the top surface 100_U of the first semiconductor die 100.

In example embodiments relating to FIG. 3A, the first detection pattern DP1 may be formed of or include a material different from the back-side insulating layer 12. The first detection pattern DP1 may include, for example, a resin layer or a polymer layer. As shown in FIG. 4A, the first detection pattern DP1 may include a first insulating pattern 11, a first diffusion protection pattern 13, and a first metal pattern 15, which are sequentially stacked. The first insulating pattern 11 may be formed of or include, for example, silicon oxide. The diffusion protection pattern 13 may be formed of at least one of Ti, TiN, Ta, or TaN. The first metal pattern 15 may be formed of at least one of metallic materials (e.g., aluminum, copper, or tungsten). The first diffusion protection pattern 13 may be also called "first diffusion prevention pattern" 13 or "first diffusion reduction pattern" 13, but the function of pattern 13 should be understood as not limited thereto.

Referring back to FIGS. 1 and 2, the second semiconductor die 200 may be a logic circuit chip, an application-specific integrated circuit (ASIC) chip, or a memory chip (e.g., a FLASH memory chip, a DRAM chip, an SRAM chip, an EEPROM chip, a PRAM chip, an MRAM chip, or an ReRAM chip). The second semiconductor die 200 may include a second substrate 20, a second interlayer insulating layer IL2, and at least one second detection pattern DP2. The second substrate 20 may be or include a semiconductor wafer, which is formed of or includes a semiconductor material (e.g., silicon), a silicon-on-insulator (SOI) wafer, and/or an insulating wafer. The second substrate 20 may include a front surface 20a and a rear surface 20b, which are opposite to each other.

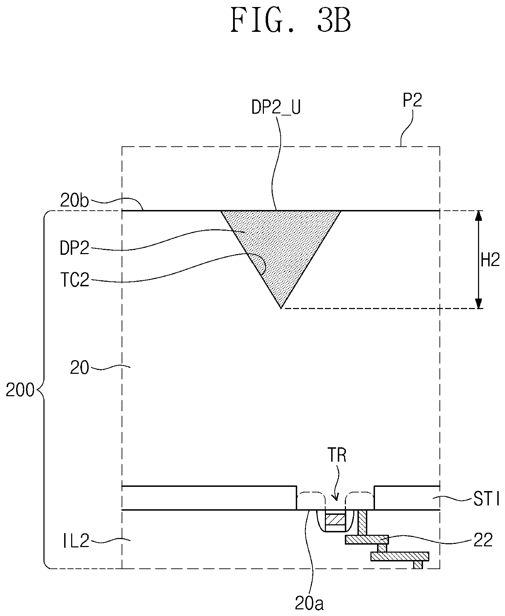

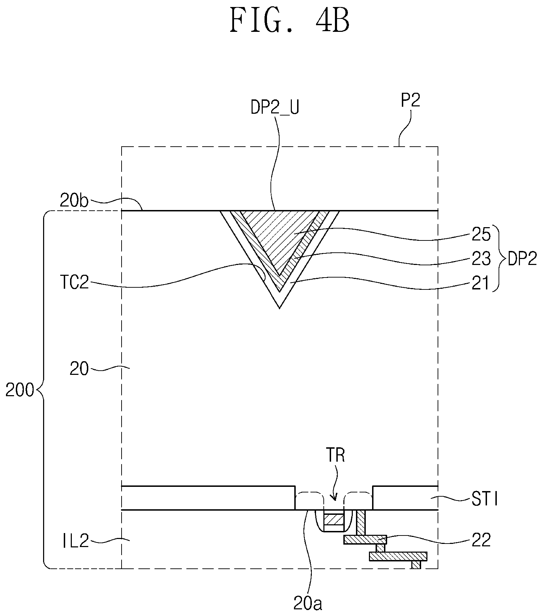

FIGS. 3B and 4B are enlarged sectional views illustrating a portion 'P2' of FIG. 2.

Referring to FIGS. 2 and 3B, a plurality of second transistors TR may be disposed on the front surface 20a of the second substrate 20. Device isolation portions STI may be disposed in the front surface 20a of the second substrate 20 to define active regions for the second transistors TR. The device isolation portions STI may be formed of or include at least one of, for example, silicon oxide, silicon nitride, or silicon oxynitride and may have a single- or multi-layered structure. The second interlayer insulating layer IL2 may be disposed on the front surface 20a of the second substrate 20. The second interlayer insulating layer IL2 may be formed of or include at least of silicon oxide, silicon nitride, silicon oxynitride, SiOCH, or SiCN and may have a single- or multi-layered structure. The second interconnection lines 22 having a multi-layered structure may be disposed in the second interlayer insulating layer IL2. The second interconnection lines 22 may be formed of or conclude at least one of doped polysilicon or metallic materials (e.g., aluminum, tungsten, titanium, and copper). The second interconnection lines 22 and the second transistors may be used to constitute various circuits.

Second connection pads CP2 may be disposed in a bottom portion of the second interlayer insulating layer IL2. The second connection pads CP2 may be formed of or include at least one of metallic materials (e.g., copper). The second connection pads CP2 may be connected to some of the second interconnection lines 22. The second connection pads CP2 may be in contact with the first connection pads CP1, respectively. In a case where the second connection pads CP2 and the first connection pads CP1 are formed of the same material, there may be no interface therebetween, but example embodiments are not limited thereto.

At least one second detection pattern DP2 may be disposed in a top portion of the second semiconductor die 200. The second detection patterns DP2 may have the same shape and size or may have different shapes and sizes. In some example embodiments, a plurality of second detection patterns DP2 may be provided and may be spaced apart from each other, as shown in FIGS. 1A to 1C. When viewed in a plan view, the second detection pattern DP2 may have a circular shape, as shown in FIGS. 1A and 1B, or may have a rectangular shape, as shown in FIG. 1C, but example embodiments are not limited thereto. The second detection pattern DP2 may have a fifth width W5 in the first direction X1. The fifth width W5 may be different from the third width W3 and/or the fourth width W4. For example, the fifth width W5 may be smaller than the third width W3 and/or the fourth width W4.

Referring to FIGS. 2, 3B, and 4B, the second detection pattern DP2 may be disposed in the second substrate 20 of the second semiconductor die 200. A top surface DP2_U of the second detection pattern DP2 may be coplanar or substantially coplanar with the rear surface 20b of the second substrate 20. The rear surface 20b of the second substrate 20 may correspond to a top surface of the second semiconductor die 200. The second detection patterns DP2 may be placed in second trenches TC2, which are formed in the rear surface 20b of the second substrate 20. An inner surface of the second trench TC2 may be inclined at an angle. The second detection pattern DP2 may have a triangular section. A width of the second detection pattern DP2 may decrease as a vertical height decreases. However, example embodiments are not limited thereto.

A reflectance of the top surface DP2_U of the second detection pattern DP2 may be different from a reflectance of the rear surface 20b of the second substrate 20. In some example embodiments, a property of the top surface DP2_U of the second detection pattern DP2 may be different from a property of the rear surface 20b of the second substrate 20. For example, the top surface DP2_U of the second detection pattern DP2 may have a hydrophobic property, and the rear surface 20b of the second substrate 20 may have a hydrophilic property. A friction coefficient of the top surface DP2_U of the second detection pattern DP2 may be different from a friction coefficient of the rear surface 20b of the second substrate 20.

In the embodiment of FIG. 3B, the second detection pattern DP2 may include, for example, a resin layer or a polymer layer. In some example embodiments, as shown in FIG. 4B, the second detection pattern DP2 may include a second insulating pattern 21, a second diffusion protection pattern 23, and a second metal pattern 25, which are sequentially stacked. The second insulating pattern 21 may be formed of silicon oxide. The second diffusion protection pattern 23 may be formed of or include at least one of materials (e.g., Ti, TiN, Ta, and TaN). The second metal pattern 25 may be formed of at least one of metallic materials (e.g., aluminum, copper, or tungsten). The second diffusion protection pattern 13 may be also called "second diffusion prevention pattern" 23 or "second diffusion reduction pattern" 23, but the function of pattern 23 should be understood as not limited thereto.

The mold layer MD may be formed of a material with high optical transmittance. For example, the mold layer MD may be formed of or include, for example, silicon oxide. In some example embodiments, the mold layer MD may include an insulating resin (e.g., an epoxy molding compound (EMC)). The mold layer MD may further include fillers, which are dispersed in the insulating resin. The filler may be formed of or include, for example, silicon oxide (SiO₂), but example embodiments are not limited thereto.

In some example embodiments, since the semiconductor package 1000 includes the first detection pattern DP1 and/or the second detection pattern DP2, it may be possible to detect an end point for a chemical mechanical polishing (CMP) process on the second substrate 20 and the mold layer MD, in the process of fabricating the semiconductor package 1000. Accordingly, the semiconductor package 1000 may be fabricated to have a desired thickness. Accordingly, it may be possible to reduce a variation in thickness of the semiconductor package 1000 and improve the reliability of the semiconductor package 1000.

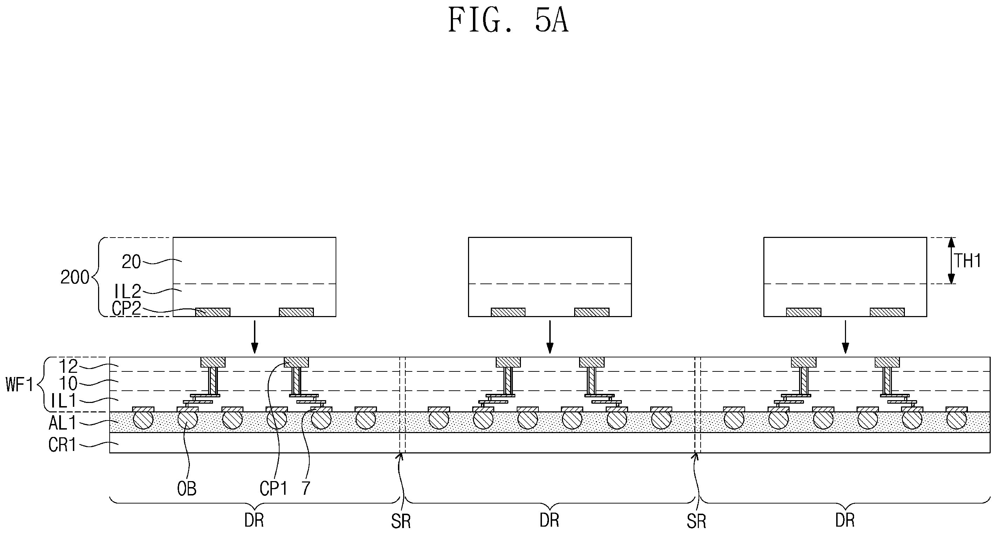

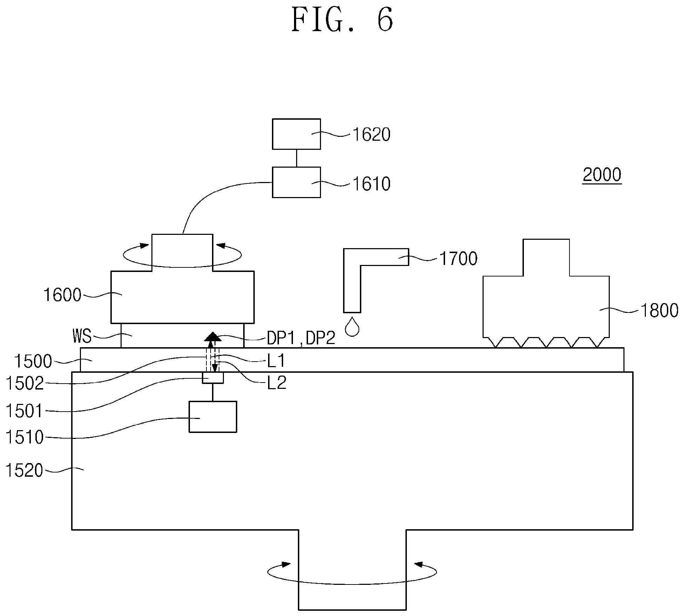

FIGS. 5A to 5G are sectional views sequentially illustrating a method of fabricating the semiconductor package of FIG. 2. FIG. 6 is a diagram illustrating a CMP device according to some example embodiments of the inventive concepts.

Referring to FIG. 5A, a first wafer WF1 may be prepared. The first wafer WF1 may include a plurality of device regions DR and a separation region SR therebetween. In each of the device regions DR, the first wafer WF 1 may have the same or similar structure as the first semiconductor die 100 described with reference to FIGS. 1A and 2. The first wafer WF1 may include the first substrate 10, the first interlayer insulating layer IL1, the back-side insulating layer 12, the first interconnection lines 5, the first bonding pads 7, the first connection pads CP1, the penetration via TV, and the via insulating layer TL. The outer connection terminals OB may be bonded to the first bonding pads 7. The first wafer WF 1 may be attached to a first carrier substrate CR1 using a sacrificial adhesive layer AL1 interposed therebetween. The sacrificial adhesive layer AL1 may be, for example, formed of or include a thermo-setting resin or a photo-curable resin, but example embodiments are not limited thereto.

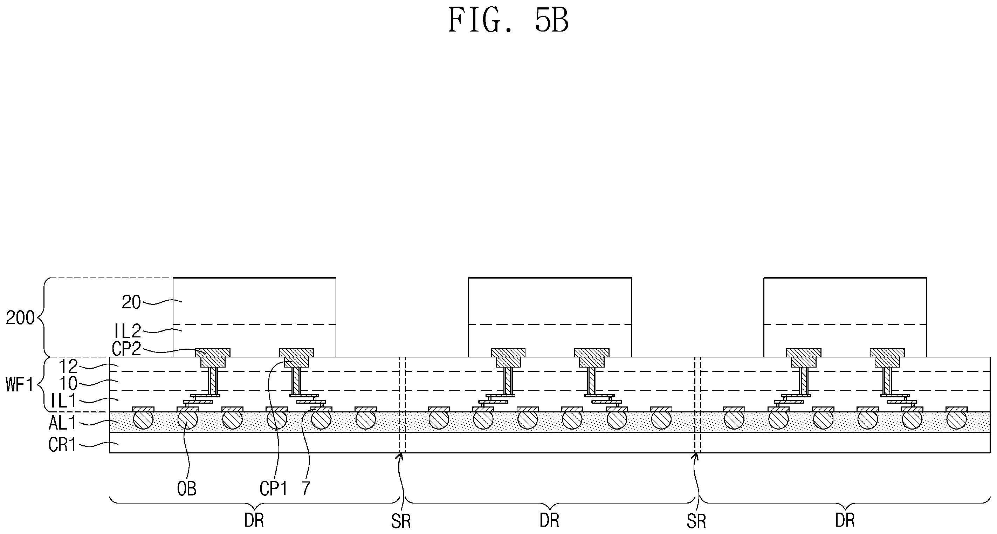

Referring to FIGS. 5A and 5B, the second semiconductor dies 200 may be prepared. Each of the second semiconductor dies 200 may include the second substrate 20, the second interlayer insulating layer IL2, and the second connection pads CP2. Here, the second substrate 20 may have a first thickness TH1. The second semiconductor dies 200 may be placed on the device regions DR, respectively, of the first wafer WF1, and then, a thermocompression process may be performed to bond the second semiconductor dies 200 to the device regions DR, respectively, of the first wafer WF1. Accordingly, the first connection pads CP1 may be bonded to the second connection pads CP2, respectively. A top surface of the back-side insulating layer 12 may be bonded to a bottom surface of the second interlayer insulating layer IL2.

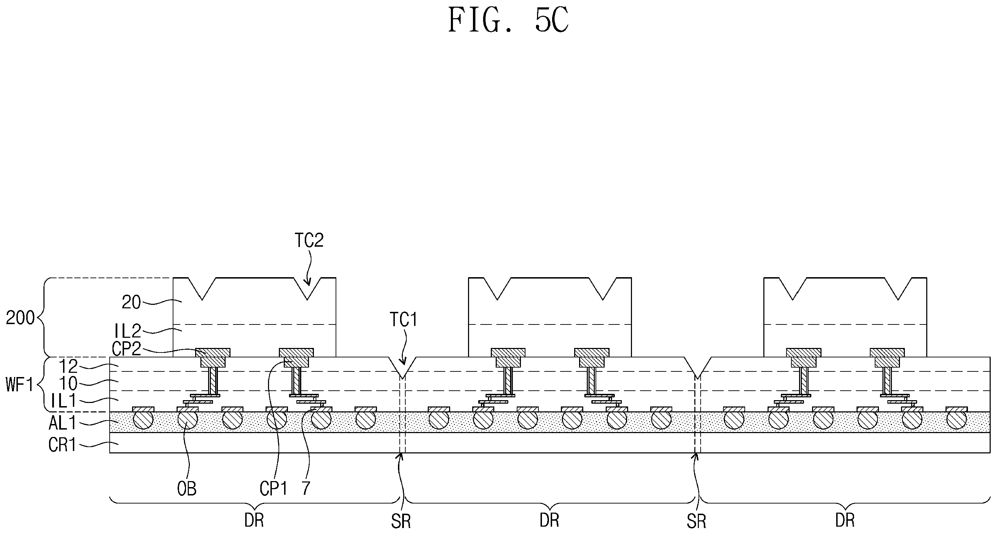

Referring to FIG. 5C, a first etching process may be performed to form (for example, define) the first trenches TC1 in a top surface of the first wafer WF1. A second etching process may be performed to form (for example, define) the second trenches TC2 in a rear surface of the second substrate 20. The first and second etching processes may be simultaneously or sequentially performed. The first and second trenches TC1 and TC2 may be formed to have the same shape and the same depth. Alternatively, the first and second trenches TC1 and TC2 may be formed to have different shapes and different depths from each other. The first trenches TC1 may be formed on the separation region SR.

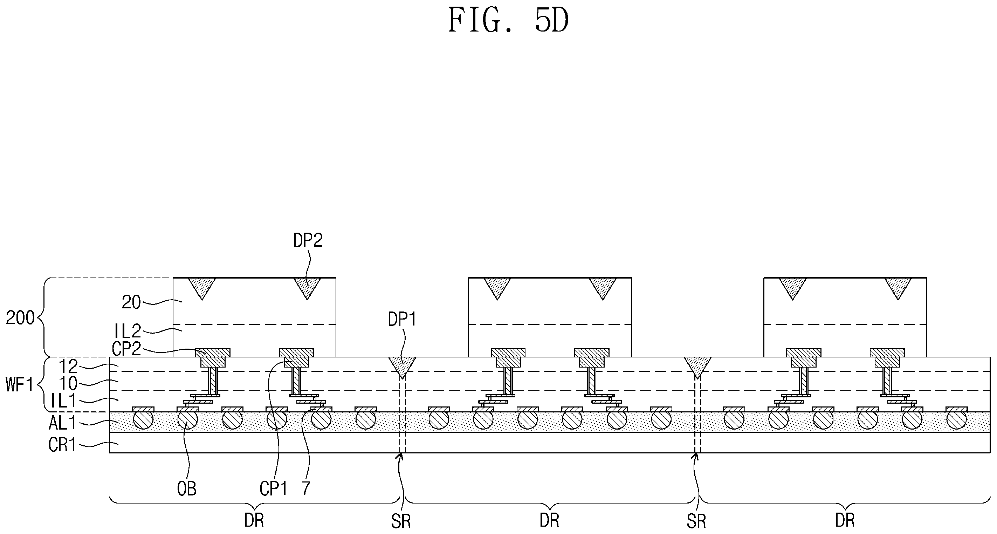

Referring to FIG. 5D, the first detection patterns DP1 may be formed in the first trenches TC1, respectively, and the second detection patterns DP2 may be formed in the second trenches TC2, respectively. The first and second detection patterns DP1 and DP2 may be formed of or include a resin and/or polymer layer, as in some embodiments related to FIGS. 3A and 3B. Alternatively, the first and second detection patterns DP1 and DP2 may be formed to include at least one of the insulating patterns 11 and 21, the diffusion protection patterns 13 and 23, and the metal patterns 15 and 25, as in example embodiments related to FIGS. 4A and 4B. The first and second detection patterns DP1 and DP2 may differ from neighboring patterns in optical reflectance or surface properties (e.g., hydrophobicity, hydrophilicity, friction coefficient, etc.).

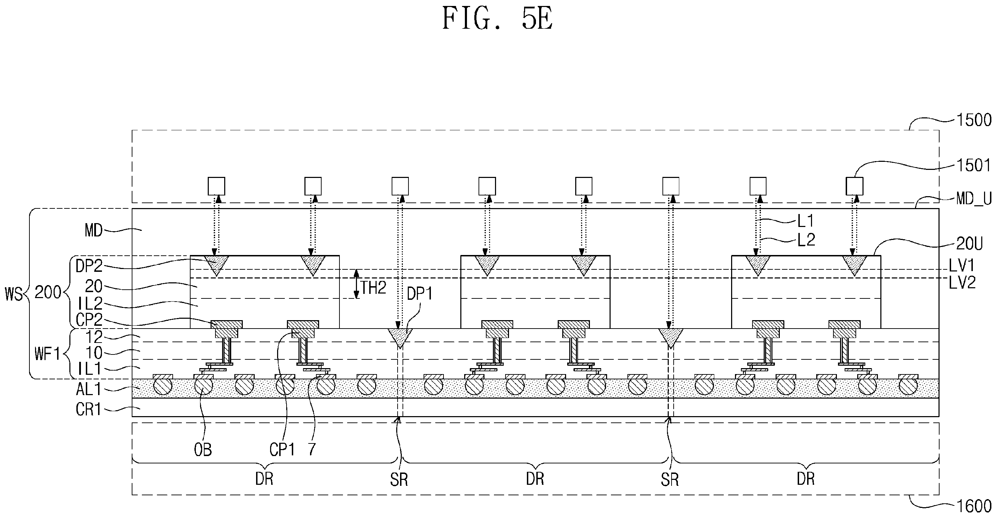

Referring to FIGS. 5E and 6, the mold layer MD may be formed on the first wafer WF1. The mold layer MD may be formed of silicon oxide or an epoxy mold compound. The first wafer WF1 covered or at least partially covered with the mold layer MD may be referred to as a wafer structure WS. A CMP process may be performed to remove a portion of the mold layer MD and a portion of the second substrate 20. Thus, the second substrate 20 may have a second thickness TH2. The second thickness TH2 may be smaller than the first thickness TH1 of FIG. 5A. The CMP process may include loading the wafer structure WS on a CMP device 2000.

Referring to FIGS. 5E and 6, the CMP device 2000 may include a rotary unit 1600, which is used to support and compress the wafer structure WS, a polishing pad 1500, which is in contact with a surface of the wafer structure WS, a rotary plate 1520, which is configured to rotate along with the polishing pad 1500 attached thereto, a conditioner 1800, which is used to restore a surface state of the polishing pad 1500, and a slurry supplying nozzle 1700, which is configured to supply a CMP slurry to the polishing pad 1500. The CMP device 2000 may include an electric motor 1610 transferring a rotational power to the rotary unit 1600 and a first controller 1620 sensing and controlling a driving state of the electric motor 1610. An optical waveguide 1502 may be provided in the polishing pad 1500 and may be configured to allow the transmission of light L1 and L2. A light generating/sensing sensor 1501 may be provided in the rotary plate 1520 and may be configured to generate and transmit a first light L1 to the wafer structure WS through the optical waveguide 1502 and to sense a second light L2 reflected from the wafer structure WS. A second controller 1510 may be provided in the rotary plate 1520 and may be used to control the light generating/sensing sensor 1501.

The first and second detection patterns DP1 and DP2 described with reference to FIG. 5E may be disposed in the wafer structure WS. The wafer structure WS may be inverted and may be fastened to a bottom surface of the rotary unit 1600, and then a CMP process on a surface of the wafer structure WS may be performed by bringing the surface of the wafer structure WS into close contact with the polishing pad 1500, rotating the rotary unit 1600 and the rotary plate 1520, and supplying a CMP slurry through the slurry supplying nozzle 1700. In the CMP process, the detection patterns DP1 and DP2 may be used as an end point of the CMP process.

For example, during the CMP process, the first light L1 generated by the light generating/sensing sensor 1501 may be reflected from surfaces of the detection patterns DP1 and DP2, and a portion of the first light L1 may be returned as the second light L2. Since the thickness of the mold layer MD is reduced by the CMP process, the optical transmittance of the mold layer MD may be improved. Accordingly, the intensity of the second light L2 reflected by the first detection pattern DP1 may be increased, and this may make it possible to precisely measure the thickness of the mold layer MD. Accordingly, it may be possible to detect and determine the end point of the CMP process.

In some example embodiments, since a portion of the second substrate 20 is gradually removed by the polishing or grinding process, the second detection pattern DP2 may also be gradually removed. Accordingly, an upper surface area of the second detection pattern DP2 may be reduced, and accordingly, an amount of the second light L2, which is reflected by a top surface of the second detection pattern DP2, may be gradually decreased. Accordingly, the remaining thickness of the second substrate 20 may be estimated (for example, precisely estimated). Accordingly, it may be possible to detect and determine the end point of the CMP process.

In some example embodiments, the top surface of the second detection pattern DP2 may have a hydrophobic property, and the second substrate 20 may have a hydrophilic property. Here, when both the second detection pattern DP2 and the second substrate 20 are polished, as the second detection pattern DP2 may be gradually removed during the polishing process, the top surface of the second semiconductor die 200 may have only the hydrophilic property, and this may lead to a change in a current amount of the electric motor 1610 rotating the rotary unit 1600. For example, in a case where the top surface of the second semiconductor die 200 has a hydrophobic property, the current amount of the electric motor 1610 rotating the rotary unit 1600 may be relatively increased to perform the polishing process normally. By contrast, in a case where the top surface of the second semiconductor die 200 has a hydrophilic property, the current amount of the electric motor 1610 rotating the rotary unit 1600 may be relatively reduced. By sensing a change in the current amount of the electric motor 1610, it may be possible to detect and determine the end point of the CMP process.

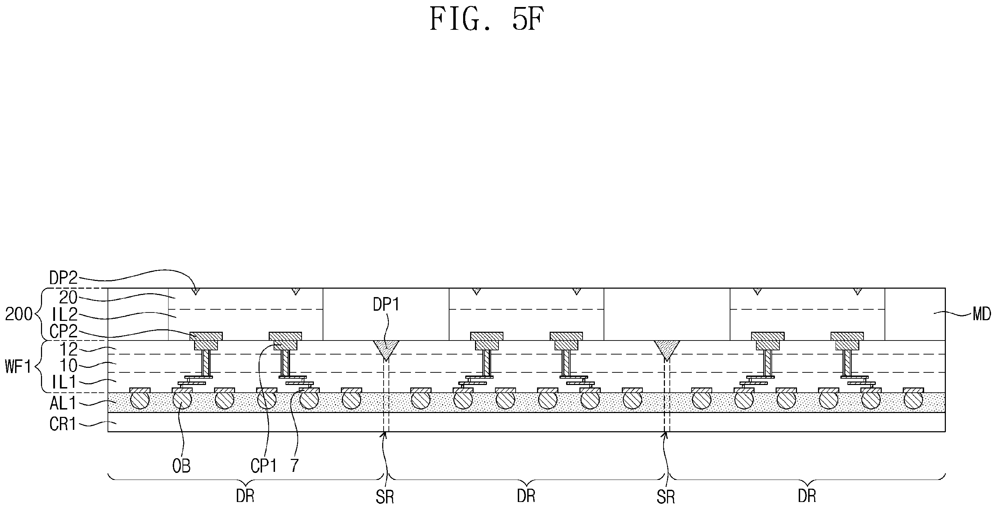

Referring to FIGS. 5E and 5F, the end point of the CMP process may be detected and determined using a difference in surface reflectance or surface state between the first and second detection patterns DP1 and DP2, as described above. Thus, the CMP process may be precisely terminated at a first level LV1 of FIG. 5E. In this case, a significant portion of the second detection patterns DP2 may be removed, leaving only a part remaining, as shown in FIG. 5F. In other example embodiments, the CMP process may be terminated at a second level LV2 of FIG. 5E. In this case, the second detection patterns DP2 may be fully removed and may not be left.

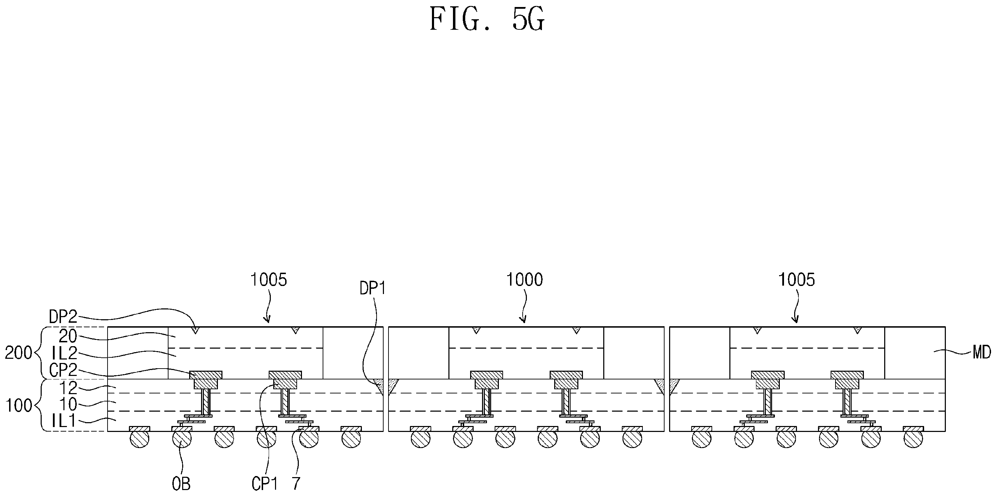

Referring to FIG. 5G, the first wafer WF1 may be separated from the sacrificial adhesive layer AL1 and the first carrier substrate CR1. Then, a singulation process may be performed to cut the separation region SR of the first wafer WF1 and the mold layer MD thereon. Thus, semiconductor packages 1000 and 1005 may be fabricated. The first detection patterns DP1 may also be cut by the singulation process. The first detection patterns DP1 may be partially left in the semiconductor packages 1000 and 1005.

In a method of fabricating a semiconductor package according to some example embodiments of the inventive concepts, the second substrate 20 may be fabricated to have a uniform and desired thickness (e.g., TH2), and accordingly, a total thickness of the semiconductor packages 1000 and 1005 may be controlled to have a uniform value, or substantially so. Accordingly, it may be possible to reduce process failure and/or increase yield.

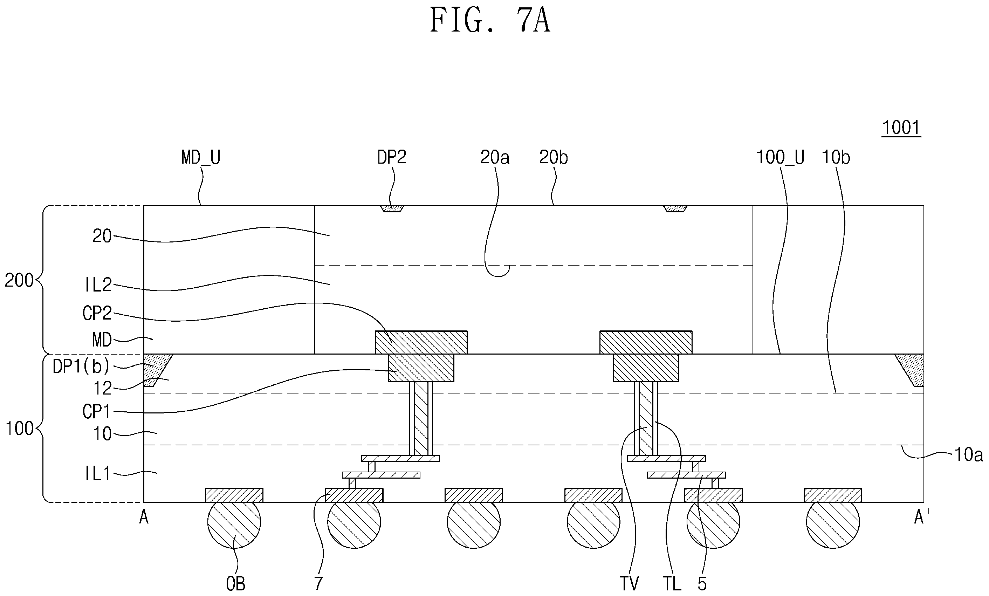

FIG. 7A is a sectional view illustrating a semiconductor package according to some example embodiments of the inventive concepts.

Referring to FIG. 7A, in a semiconductor package 1001 according to some example embodiments of the inventive concepts, the first and second detection patterns DP1 and DP2 may have different trapezoidal shapes as each other. Each of the first and second detection patterns DP1 and DP2 may have a decreasing width as a vertical level decreases. A height of the first detection pattern DP1 may be larger than a height of the second detection pattern DP2. Except for the above features, the semiconductor package may be configured to have the same, substantially the same, or similar features as one of the semiconductor packages described with reference to FIGS. 1A to 4B.

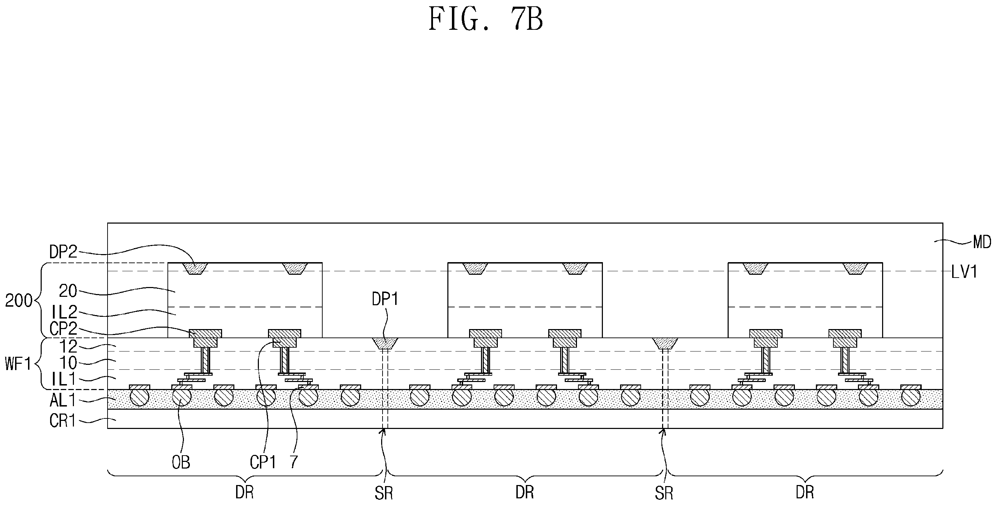

FIG. 7B is a sectional view illustrating a process of fabricating the semiconductor package of FIG. 7A.

Referring to FIG. 7B, in the process described with reference to FIG. 5D, the first and second detection patterns DP1 and DP2 may be formed to have the same trapezoidal shape. Next, the CMP process in the process described with reference to FIG. 5E may be terminated at the first level LV1. Next, the subsequent processes of FIGS. 5F and 5G may be performed to fabricate the semiconductor package of FIG. 7A.

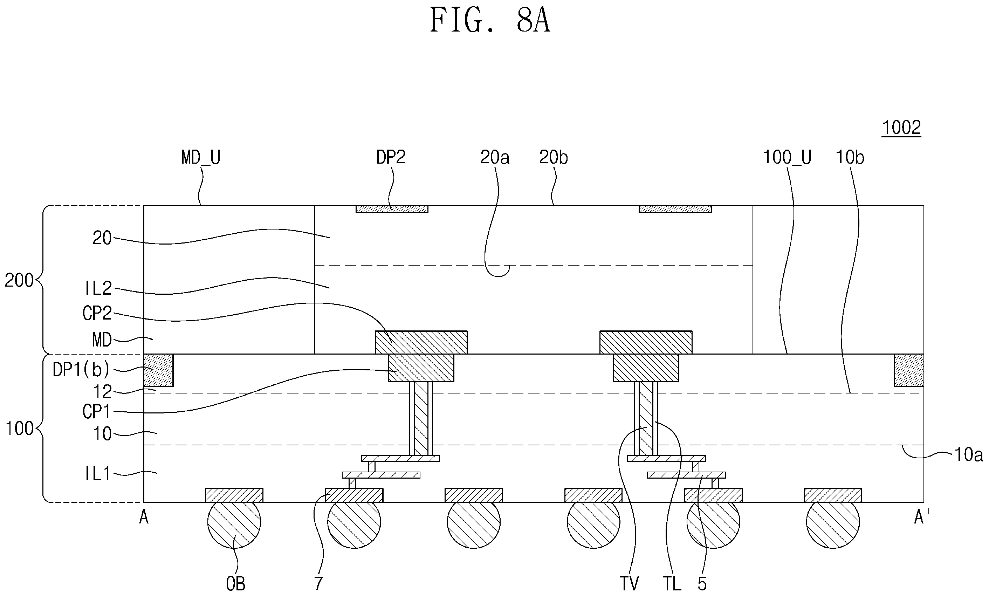

FIG. 8A is a sectional view illustrating a semiconductor package according to some example embodiments of the inventive concepts.

Referring to FIG. 8A, in a semiconductor package 1002 according to some example embodiments of the inventive concepts, the first and second detection patterns DP1 and DP2 may have different rectangular shapes from each other. A height of the first detection pattern DP1 may be larger than a height of the second detection pattern DP2. A width of the first detection pattern DP1 may be larger than a width of the second detection pattern DP2. Except for the above features, the semiconductor package may be configured to have the same, substantially the same, or similar features as one of the semiconductor packages described with reference to FIGS. 1A to 4B.

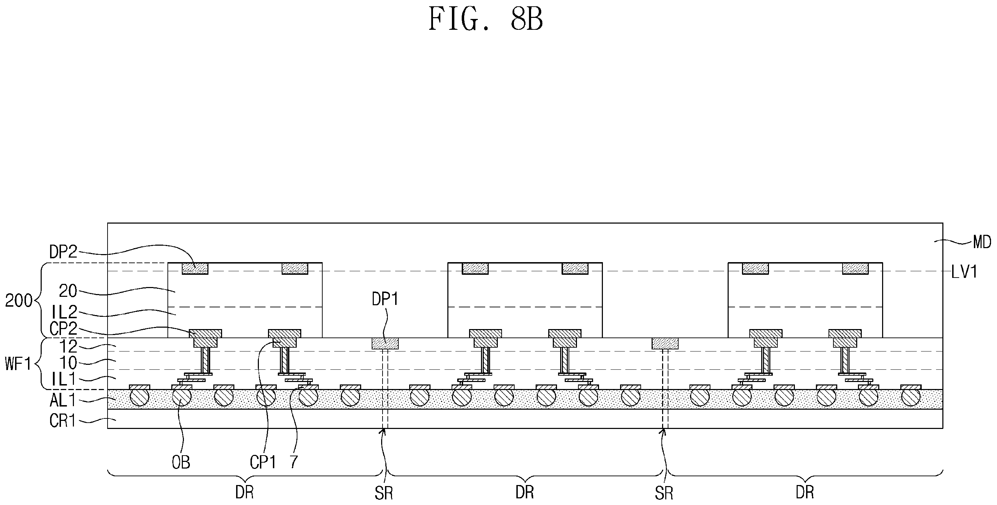

FIG. 8B is a sectional view illustrating a process of fabricating the semiconductor package of FIG. 8A.

Referring to FIG. 8B, in the process described with reference to FIG. 5D, the first and second detection patterns DP1 and DP2 may be formed to have the same rectangular shape. Next, the CMP process in the process described with reference to FIG. 5E may be terminated at the first level LV1. Next, the subsequent processes of FIGS. 5F and 5G may be performed to fabricate the semiconductor package of FIG. 8A.

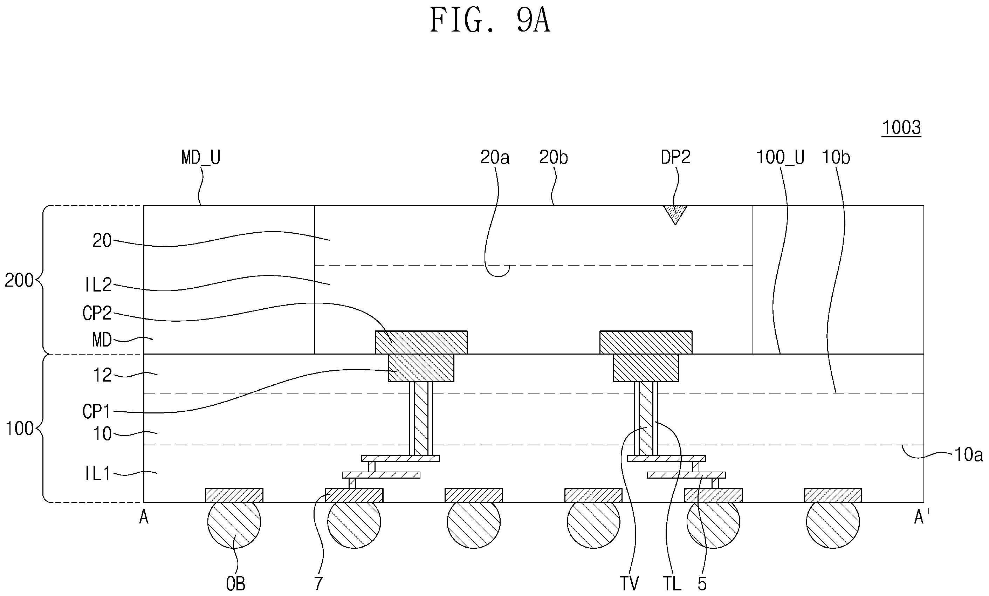

FIG. 9A is a sectional view illustrating a semiconductor package according to some example embodiments of the inventive concepts.

Referring to FIG. 9A, the first detection patterns DP1 may be omitted in a semiconductor package 1003 according to some example embodiments of the inventive concepts. The semiconductor package 1003 may include only one second detection pattern DP2. Except for the above features, the semiconductor package may be configured to have the same, substantially the same, or similar features as one of the semiconductor packages described with reference to FIG. 2.

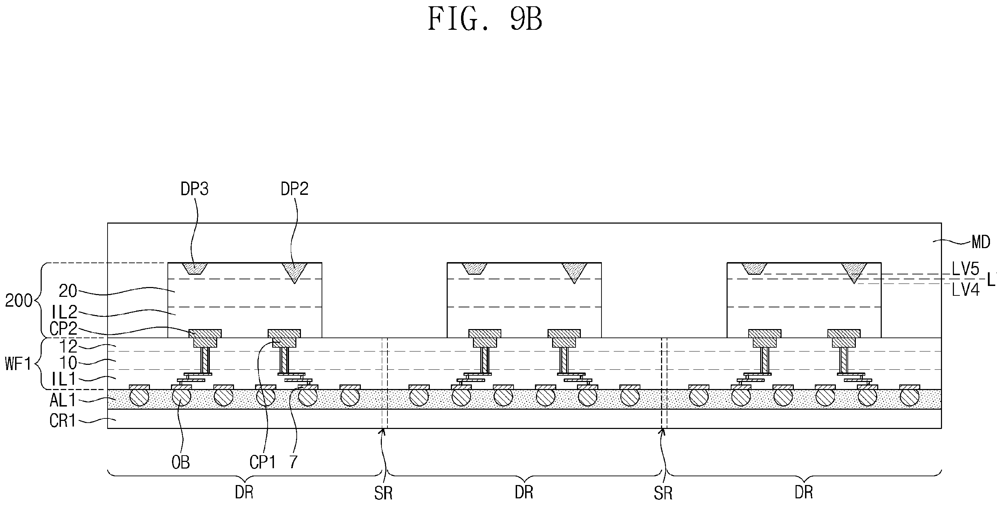

FIG. 9B is a sectional view illustrating a process of fabricating the semiconductor package of FIG. 9A.

Referring to FIG. 9B, in the process described with reference to FIG. 5D, the second semiconductor die 200 may be formed to include the second detection pattern DP2 and a third detection pattern DP3, which are spaced apart from each other. The second and third detection patterns DP2 and DP3 may be formed to have different shapes and heights from each other. For example, the second detection pattern DP2 may have a triangular section, and the third detection pattern DP3 may have a trapezoidal shape. A fourth level LV4 of a bottom end of the second detection pattern DP2 may be lower than a fifth level LV5 of a bottom end of the third detection pattern DP3. Next, the CMP process in the process described with reference to FIG. 5E may be terminated at the first level LV1. The first level LV1 may be higher than the fourth level LV4 and may be lower than the fifth level LV5. In this case, as a result of the CMP process, the third detection pattern DP3 may be completely removed, and a portion of the second detection pattern DP2 may be left. Next, the subsequent processes of FIGS. 5F and 5G may be performed to fabricate the semiconductor package of FIG. 9A.

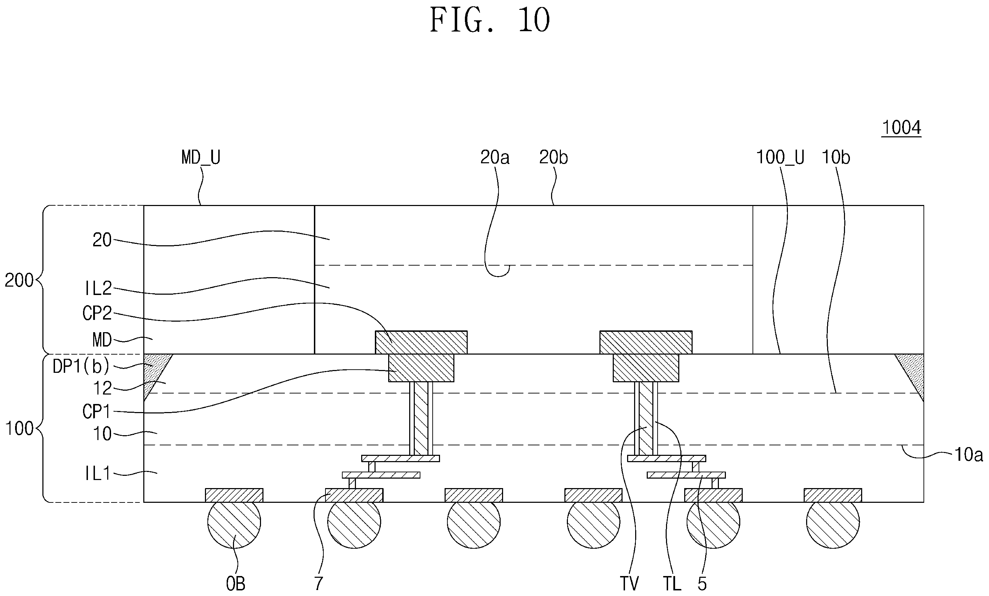

FIG. 10 is a sectional view illustrating a semiconductor package according to some example embodiments of the inventive concepts.

Referring to FIG. 10, a semiconductor package 1004 according to some example embodiments of the inventive concepts may include the first detection patterns DP1, but the second detection patterns DP2 may be omitted from the semiconductor package 1004. Except for the above features, the semiconductor package may be configured to have the same, substantially the same, or similar features as one of the semiconductor packages described with reference to FIGS. 1A to 4B. The semiconductor package 1004 of FIG. 10 may be fabricated when the CMP process in the step of FIG. 5E is stopped at the second level LV2.

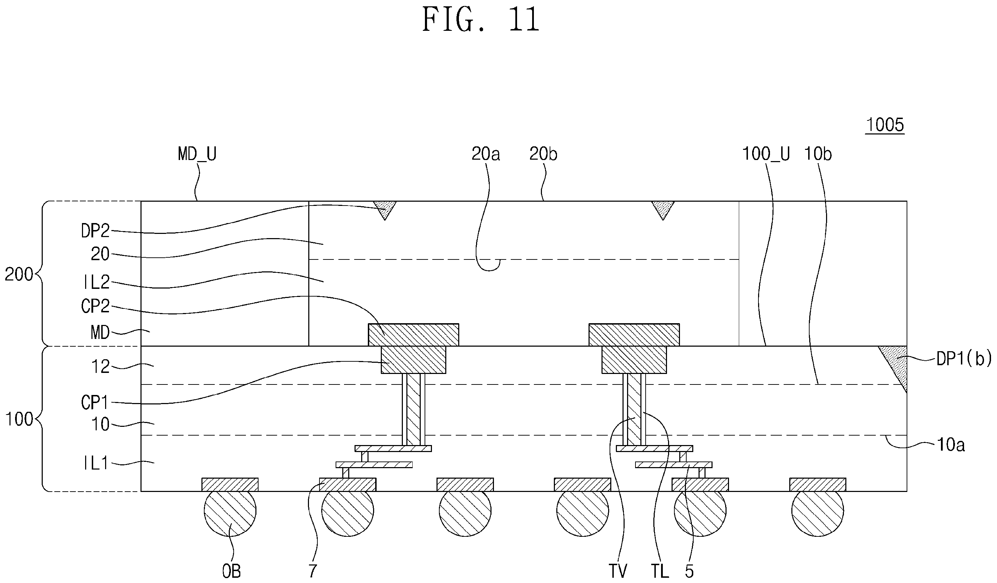

FIG. 11 is a sectional view illustrating a semiconductor package according to some example embodiments of the inventive concepts.

Referring to FIG. 11, a semiconductor package 1005 according to some example embodiments of the inventive concepts may include one first detection pattern DP1 and two second detection patterns DP2. Except for the above features, the semiconductor package may be configured to have substantially the same or similar features as one of the semiconductor packages described with reference to FIGS. 1A to 4B. The device region DR, which is located at an edge of the first wafer WF1 in FIGS. 5F and 5G, may be used as the semiconductor package 1005 of FIG. 11 after the singulation process.

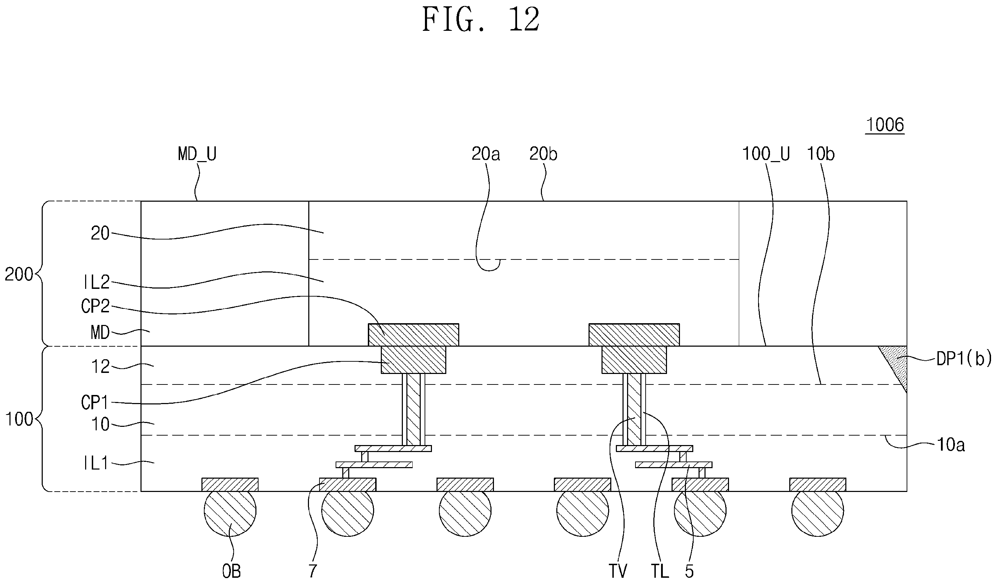

FIG. 12 is a sectional view illustrating a semiconductor package according to some example embodiments of the inventive concepts.

Referring to FIG. 12, a semiconductor package 1006 according to some example embodiments of the inventive concepts may include only one first detection pattern DP1. Except for the above features, the semiconductor package may be configured to have the same, substantially the same or similar features as one of the semiconductor packages described with reference to FIGS. 1A to 4B.

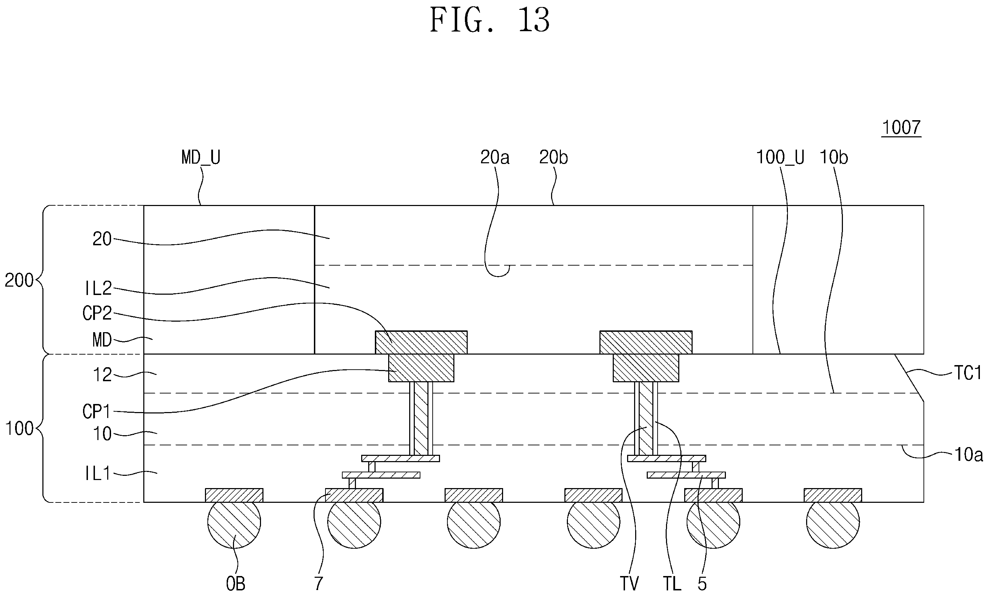

FIG. 13 is a sectional view illustrating a semiconductor package according to some example embodiments of the inventive concepts.

Referring to FIG. 13, a semiconductor package 1007 according to some example embodiments of the inventive concepts may have the same or substantially the same structure as the semiconductor package 1006 of FIG. 12, except that the first detection pattern DP1 is absent. In such a case, the first trench TC1 may be formed in an upper side surface of the first semiconductor die 100. The first trench TC1 may be formed to expose a bottom surface of the mold layer MD. The semiconductor package 1007 of FIG. 13 may be fabricated when the first detection pattern DP1 is detached from the first semiconductor die 100 in the singulation process of FIG. 5G.

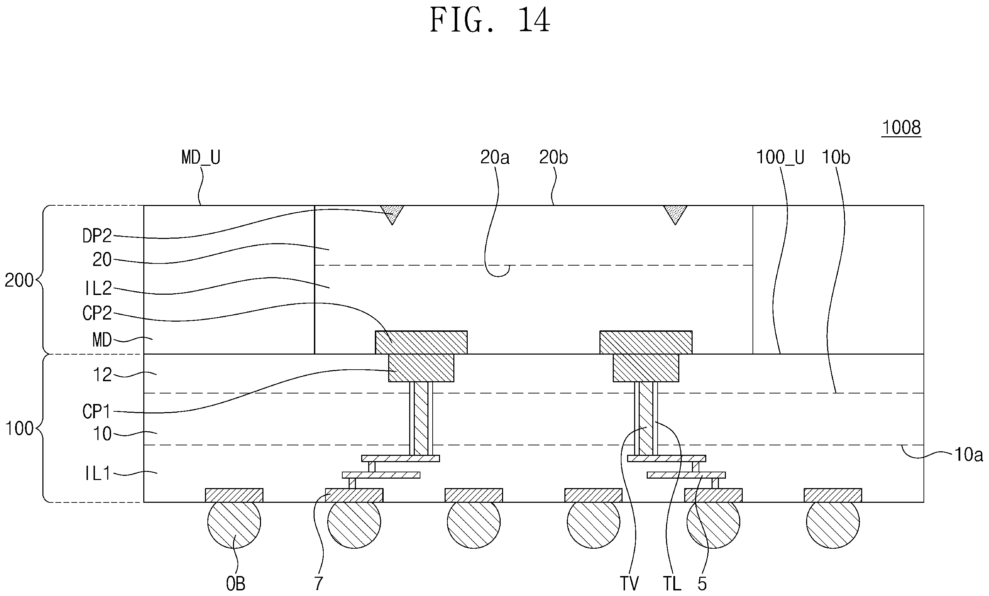

FIG. 14 is a sectional view illustrating a semiconductor package according to some example embodiments of the inventive concepts.

Referring to FIG. 14, a semiconductor package 1008 according to some example embodiments of the inventive concepts may have substantially the same structure as the semiconductor package 1000 of FIG. 2, except that the first detection pattern DP1 is absent. Except for the above features, the semiconductor package may be configured to have the same, substantially the same, or similar features as one of the semiconductor packages described with reference to FIGS. 1A to 4B.

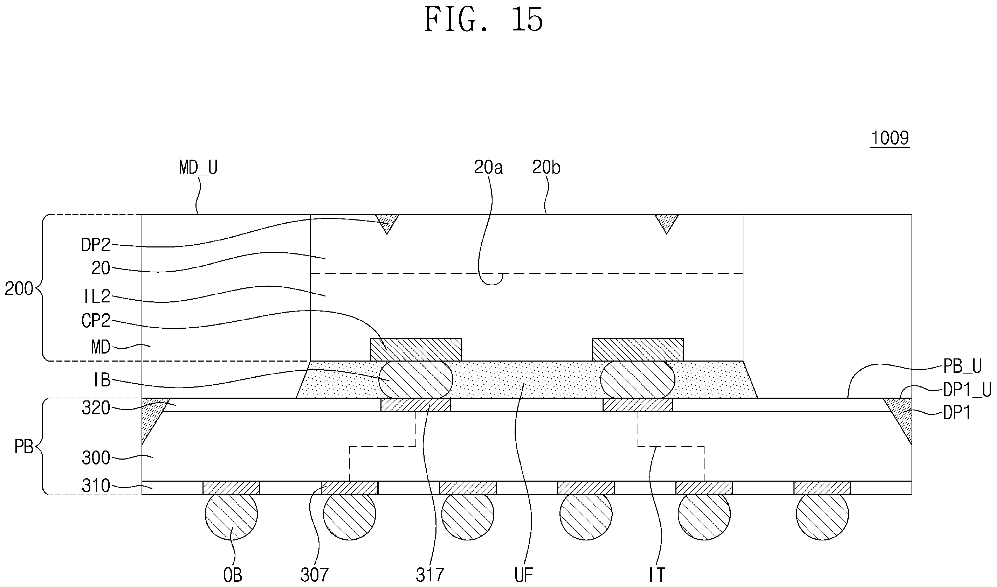

FIG. 15 is a sectional view illustrating a semiconductor package according to some example embodiments of the inventive concepts.

Referring to FIG. 15, a semiconductor package 1009 according to some example embodiments of the inventive concepts may have the same or substantially the same structure as the semiconductor package 1000 of FIG. 2, except that a package substrate PB is provided in placed of the first semiconductor die 100. The package substrate PB may be a double-sided or multi-layered printed circuit board or a redistribution substrate. The package substrate PB may include a substrate body portion 300, an upper photoimageable insulating layer 320, and a lower photoimageable insulating layer 310. In a case where the package substrate PB is a printed circuit board, the substrate body portion 300 may, for example, be formed of or include at least one of thermosetting resins (e.g., epoxy resin), thermoplastic resins (e.g., polyimide), composite materials (e.g., prepreg), in which a reinforcement element (e.g., glass fiber and/or inorganic filler) is pre-impregnated with a thermoplastic or thermosetting resin matrix, or photo-curable resins, but the inventive concepts are not limited to these examples. The upper photoimageable insulating layer 320 and the lower photoimageable insulating layer 310 may be formed of a photo-solder resist (PSR) material. In the case where the package substrate PB is or includes a redistribution substrate, the substrate body portion 300, the upper photoimageable insulating layer 320, the lower photoimageable insulating layer 310 may be formed of a photo-imageable dielectric (PID) material, but example embodiments are not limited thereto.

The package substrate PB may further include an upper substrate pattern 317, a lower substrate pattern 307, an inner interconnection line IT, and the first detection patterns DP1. The inner interconnection line IT may connect the upper substrate pattern 317 to the lower substrate pattern 307. The upper substrate pattern 317, the lower substrate pattern 307, and the inner interconnection line IT may be formed of at least one of metallic materials (e.g., copper). The outer connection terminals OB may be bonded to the lower substrate patterns 307. The first detection patterns DP1 may be configured to have substantially the same or similar features as that in example embodiments described with reference to FIGS. 1A to 4B. The first detection patterns DP1 may be disposed along the edge and/or one or more corners of the package substrate PB.

The second semiconductor die 200 may be mounted on the package substrate PB. The second semiconductor die 200 may be configured to have substantially the same or similar features as that in the embodiment described with reference to FIGS. 1A to 4B. Inner connection members IB may be interposed between the second connection pads CP2 of the second semiconductor die 200 and the upper substrate pattern 317 of the package substrate PB. The inner connection members IB may be or include conductive bumps and/or solder balls. The inner connection members IB may be formed of, for example, SnAg, but example embodiments are not limited thereto. A space between the package substrate PB and the second semiconductor die 200 may be filled with an under-fill layer UF. The under-fill layer UF may include a thermo-setting resin or a photo-curable resin. In addition, the under-fill layer UF may further include an organic filler or an inorganic filler. Except for the above features, the semiconductor package may be configured to have the same, substantially the same, or similar features as one of the semiconductor packages described with reference to FIGS. 1A to 4B.

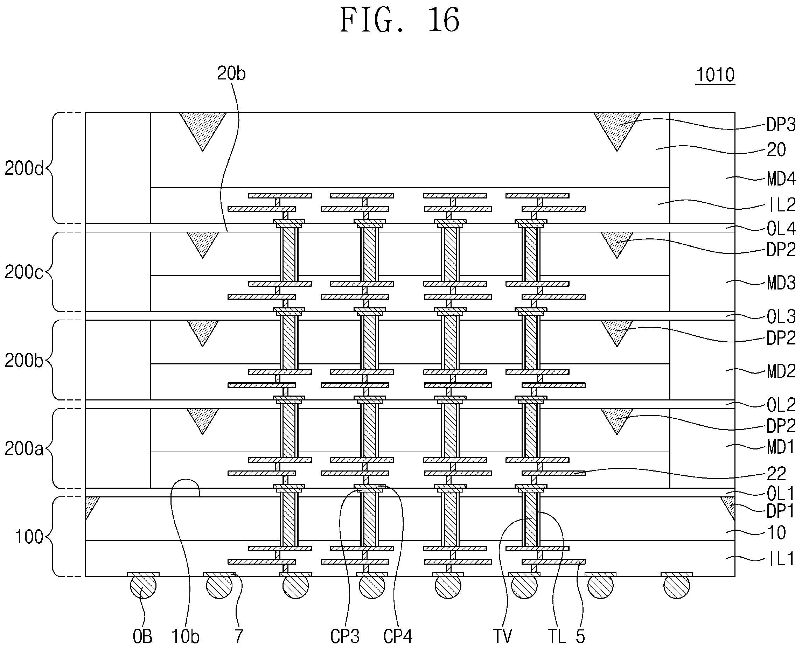

FIG. 16 is a sectional view illustrating a semiconductor package according to some example embodiments of the inventive concepts.

Referring to FIG. 16, a semiconductor package 1010 according to some example embodiments of the inventive concepts may include second to fifth semiconductor dies 200a, 200b, 200c, and 200d and first to fourth mold layers MD1 to MD4, which are sequentially stacked on the first semiconductor die 100. A width of the first semiconductor die 100 may be larger than a width of each of the second to fifth semiconductor dies 200a, 200b, 200c, and 200d. Side surfaces of the second to fifth semiconductor dies 200a, 200b, 200c, and 200d may be aligned to (for example, coplanar with) each other.

The first semiconductor die 100 may be a chip of a different kind than the second to fifth semiconductor dies 200a, 200b, 200c, and 200d. The first semiconductor die 100 may be, for example, a logic circuit chip or a buffer die. The second to fifth semiconductor dies 200a, 200b, 200c, and 200d may be or include memory chips of the same kind, but example embodiments are not limited thereto. The memory chip may be, for example, one of DRAM, NAND Flash, SRAM, MRAM, PRAM, and RRAM chips. The present drawing illustrates a structure in which one logic circuit chip and four memory chips are stacked, but the stacking numbers of the logic circuit chip and the memory chips are not limited thereto and may be variously changed. The first semiconductor die 100 may be wider than the second to fifth semiconductor dies 200a, 200b, 200c, and 200d. The semiconductor package 1010 may be a high bandwidth memory (HBM) chip.

The mold layer MD may cover the top surface of the first semiconductor die 100 and the side surfaces of the second to fifth semiconductor dies 200a, 200b, 200c, and 200d. A top surface of the mold layer MD may be coplanar with a rear surface of the fifth semiconductor die 200d.

The first semiconductor die 100 may include the first substrate 10, the first interlayer insulating layer IL1, the first interconnection lines 5, the first bonding pads 7, third connection pads CP3, the penetration via TV, the via insulating layer TL, and the first detection patterns DP1. A rear surface of the first substrate 10 may be covered or at least partially covered with a first back-side insulating layer OL1. The third connection pads CP3 may be disposed in the first back-side insulating layer OL1. The first back-side insulating layer OL1 may cover the entire rear surface of the first substrate 10.

The second semiconductor die 200a and the first mold layer MD1 may be disposed on the first semiconductor die 100. The second semiconductor die 200a may include the second substrate 20, the second interlayer insulating layer IL2, the first interconnection lines 5, the fourth connection pads CP4, the third connection pads CP3, the penetration via TV, the via insulating layer TL, and the second detection patterns DP2. The fourth connection pads CP4 may be placed in a bottom portion of the second interlayer insulating layer IL2. The rear surface 20b of the second substrate 20 of the second semiconductor die 200a may be covered or at least partially covered with a second back-side insulating layer OL2. The third connection pads CP3 may be disposed in the second back-side insulating layer OL2. The second back-side insulating layer OL2 may be extended to cover a top surface of the first mold layer MD1.

The third semiconductor die 200b and the second mold layer MD2 may be disposed on the second back-side insulating layer OL2. The third semiconductor die 200b may include the second substrate 20, the second interlayer insulating layer IL2, the first interconnection lines 5, the fourth connection pads CP4, the third connection pads CP3, the penetration via TV, the via insulating layer TL, and the second detection patterns DP2. The fourth connection pads CP4 may be placed in a bottom portion of the second interlayer insulating layer IL2. The rear surface 20b of the second substrate 20 of the third semiconductor die 200b may be covered or at least partially covered with a third back-side insulating layer OL3. The third connection pads CP3 may be disposed in the second back-side insulating layer OL2. The third back-side insulating layer OL3 may be extended to cover a top surface of the second mold layer MD2.

The fourth semiconductor die 200c and the third mold layer MD3 may be disposed on the third back-side insulating layer OL3. The fourth semiconductor die 200c may include the second substrate 20, the second interlayer insulating layer IL2, the first interconnection lines 5, the fourth connection pads CP4, the third connection pads CP3, the penetration via TV, the via insulating layer TL, and the second detection patterns DP2. The fourth connection pads CP4 may be placed in a bottom portion of the second interlayer insulating layer IL2. The rear surface 20b of the second substrate 20 of the fourth semiconductor die 200c may be covered or at least partially covered with a fourth back-side insulating layer OL4. The third connection pads CP3 may be disposed in the second back-side insulating layer OL2. The fourth back-side insulating layer OL4 may be extended to cover a top surface of the third mold layer MD3.

The fifth semiconductor die 200d and the fourth mold layer MD4 may be disposed on the fourth back-side insulating layer OL4. The fifth semiconductor die 200d may include the second substrate 20, the second interlayer insulating layer IL2, the first interconnection lines 5, the fourth connection pads CP4, and the third detection patterns DP3. The fourth connection pads CP4 may be placed in a bottom portion of the second interlayer insulating layer IL2.

The first detection patterns DP1, the second detection patterns DP2, and the third detection patterns DP3 may have different shapes and sizes. For example, the first detection patterns DP1 may have a different shape from the second and third detection patterns DP2 and DP3. The third detection patterns DP3 may have widths and heights that are larger than those of the first and second detection patterns DP1 and DP2.

Each of the first to fourth back-side insulating layers OL1 to OL4 may be formed of or include at least one of silicon oxide, silicon nitride, silicon oxynitride, or SiCN and may have a single- or multi-layered structure. Each of the first to fourth mold layers MD1 to MD4 may be formed or include of silicon oxide and/or an epoxy mold compound, but example embodiments are not limited thereto. In a case where the first to fourth back-side insulating layers OL1 to OL4 and the first to fourth mold layers MD1 to MD4 are formed of the same material (e.g., silicon oxide), an interface therebetween may not be visible or observable and they may be observed as a single object, but example embodiments are not limited thereto. Except for the above features, the semiconductor package may be configured to have the same, substantially the same features as one of the semiconductor packages described with reference to FIGS. 1 to 14.

In a semiconductor package according to some example embodiments of the inventive concepts and a method of fabricating the same, a detection pattern may be provided in at least one of a wafer and a semiconductor die and may be used to detect (for example, precisely detect) an end point of a chemical mechanical polishing (CMP) process, which may be performed on the semiconductor die and a mold layer in a process of fabricating the semiconductor package. Accordingly,, the semiconductor package may be fabricated to have a desired thickness. Accordingly, it may be possible to reduce a variation in thickness of the semiconductor package and improve the reliability of the semiconductor package. Moreover, it may be possible to reduce process failure and/or increase a yield in the fabrication process.

While example embodiments of the inventive concepts have been particularly shown and described, it will be understood by one of ordinary skill in the art that variations in form and detail may be made therein without departing from the spirit and scope of the attached claims. The embodiments of FIGS. 1A to 16 may be combined to realize the inventive concepts.

Singular expressions may include plural expressions unless the context clearly indicates otherwise. Terms, such as "include" or "has" may be interpreted as adding features, numbers, steps, operations, components, parts, or combinations thereof described in the specification.

It will be understood that when an element or layer is referred to as being "on", "connected to", "coupled to", "attached to", or "in contact with" another element or layer, it can be directly on, connected to, coupled to, attached to, or in contact with the other element or layer, or intervening elements or layers may be present. In contrast, when an element is referred to as being "directly on", "directly connected to", "directly coupled to", "directly attached to", or "in direct contact with" another element or layer, there are no intervening elements or layers present. As used herein, the term "and/or" includes any and all combinations of one or more of the associated listed items.

When the terms "about" or "substantially" are used in this specification in connection with a numerical value, it is intended that the associated numerical value includes a manufacturing or operational tolerance (e.g., ±10%) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

It will be understood that elements and/or properties thereof may be recited herein as being "the same" or "equal" as other elements, and it will be further understood that elements and/or properties thereof recited herein as being "identical" to, "the same" as, or "equal" to other elements may be "identical" to, "the same" as, or "equal" to or "substantially identical" to, "substantially the same" as or "substantially equal" to the other elements and/or properties thereof. Elements and/or properties thereof that are "substantially identical" to, "substantially the same" as or "substantially equal" to other elements and/or properties thereof will be understood to include elements and/or properties thereof that are identical to, the same as, or equal to the other elements and/or properties thereof within manufacturing tolerances and/or material tolerances. Elements and/or properties thereof that are identical or substantially identical to and/or the same or substantially the same as other elements and/or properties thereof may be structurally the same or substantially the same, functionally the same or substantially the same, and/or compositionally the same or substantially the same.

Spatially relative terms (e.g., "beneath," "below," "lower," "above," "upper," and the like) may be used herein for ease of description to describe one element or feature's relationship to another element(s) or feature(s) as illustrated in the figures. It should be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" may encompass both an orientation of above and below. The device may be otherwise oriented (rotated 90 degrees or at other at other orientations) and the spatially relative descriptors used herein interpreted accordingly.

## Claims

1. A semiconductor package, comprising:
a first semiconductor die having a first width;
a second semiconductor die on the first semiconductor die, the second semiconductor die having a second width that is smaller than the first width; and
a mold layer at least partially covering
a side surface of the second semiconductor die, and
a top surface of the first semiconductor die,
wherein the first semiconductor die comprises at least one first detection pattern, the at least one first detection pattern being on the top surface of the first semiconductor die and in contact with a bottom surface of the mold layer.

2. The semiconductor package of claim 1, wherein the first detection pattern has a triangular, trapezoidal, or rectangular section.

3. The semiconductor package of claim 1, wherein the first detection pattern has an arc, semicircular, or rectangular shape, when viewed in a plan view.

4. The semiconductor package of claim 1, wherein the mold layer includes at least one of an oxide material or an epoxy mold compound.

5. The semiconductor package of claim 1, wherein a reflectance of the first detection pattern is different from a reflectance of the top surface of the first semiconductor die.

6. The semiconductor package of claim 1, wherein the first detection pattern comprises at least one of a metal, a polymer, or a resin.

7. The semiconductor package of claim 1, wherein the second semiconductor die comprises at least one second detection pattern, the at least one second detection pattern being on a top surface of the second semiconductor die and spaced apart from the mold layer.

8. The semiconductor package of claim 7, wherein the second detection pattern has a triangular, trapezoidal, or rectangular section.

9. The semiconductor package of claim 7, wherein a reflectance of the second detection pattern is different from a reflectance of a top surface of the second semiconductor die.

10. The semiconductor package of claim 7, wherein a top surface of the second detection pattern is hydrophobic and a top surface of the second semiconductor die is hydrophilic.

11. The semiconductor package of claim 7, wherein the second detection pattern comprises at least one of a metal, a polymer, or a resin.

12. The semiconductor package of claim 7, wherein the first detection pattern has a first height and the second detection pattern has a second height that is different from the first height.

13. The semiconductor package of claim 1, wherein the first detection pattern is on at least one of an edge or corner of the first semiconductor die.

14. The semiconductor package of claim 1, wherein a side surface of the first detection pattern is coplanar with a side surface of the mold layer.

15. The semiconductor package of claim 1, further comprising:
a third semiconductor die on the second semiconductor die,
wherein the third semiconductor die comprises at least one second detection pattern that is on a top surface of the third semiconductor die.
